(19) Europäisches Patentamt
European Patent Office
Office européen des brevets

(11) Publication number: **0 632 384 A1**

# (12) EUROPEAN PATENT APPLICATION

(21) Application number: **93480085.5**

(51) Int. Cl.[6]: **G06F 11/26**, H03K 5/15

(22) Date of filing: **30.06.93**

(43) Date of publication of application: **04.01.95 Bulletin 95/01**

(84) Designated Contracting States: **DE FR GB**

(71) Applicant: **International Business Machines Corporation**
**Old Orchard Road**
**Armonk, N.Y. 10504 (US)**

(72) Inventor: **Cantiant, Thierry**
**28 allée Edouard Manet**
**F-77190 Dammaire-Les-Lys (FR)**
Inventor: **Gabillard, Bertrand**
**7 rue Beccaria**
**F-75012 Paris (FR)**
Inventor: **Mifsud, Jean-Paul**
**74 rue des Grands Champs**
**F-77127 Lieusaint (FR)**
Inventor: **Rapoport, Stuart**
**3010 44th Place NW**
**Washington, DC 20016 (US)**

(74) Representative: **Klein, Daniel Jacques Henri**
**Compagnie IBM France**
**Département de Propriété Intellectuelle**
**F-06610 La Gaude (FR)**

## (54) High speed and programmable array clock generator circuit for abist semiconductor memory chips.

(57) An integrated circuit incorporating at least one macro of the type including a memory unit and an ABIST unit to exercise said memory unit, further including a dedicated array clock generator (ACG) circuit (40) comprising:

a first input terminal (42-1) adapted to receive a single input clock signal (D);

a second input terminal (42-2) adapted to receive a gating signal (CNOOP) from the ABIST unit;

a third input terminal (42-3) adapted to receive a control signal (STDS0) from the ABIST unit;

a signal chopper (28) comprised of a first AND gate (22) having an inherent delay DEL1 whose first input is connected to said input terminal and whose second input is connected to said input terminal via an inverter (24) and a first delay line (21-1) having a determined delay DEL2 to generate a LSSD C ungated clock signal (CACG*);

a second inverter (25) and a second delay line (21-2) having a determined delay DEL3 connected to the output of said first delay line;

a multiplexer (41) havind an inherent delay DEL5 controlled by said control signal (STDS0) whose first input is connected to the output of said second delay line via a third inverter (31) and its second input is connected to said first input terminal;

a second AND gate (23) having an inherent delay DEL4 whose first input is connected to the output of said second delay line and second input is connected to the output of said multiplexer to generate the LSSD B and S clock signals (BACG/SACG);

a third AND gate (17) whose first input is connected to the output of said firstd AND gate and second input is connected to the second input terminal to generate the LSSD C clock signal (CACG);

said control signal selects which of the two circuit configuration is optimal depending on the ABIST sub-mode.

EP 0 632 384 A1

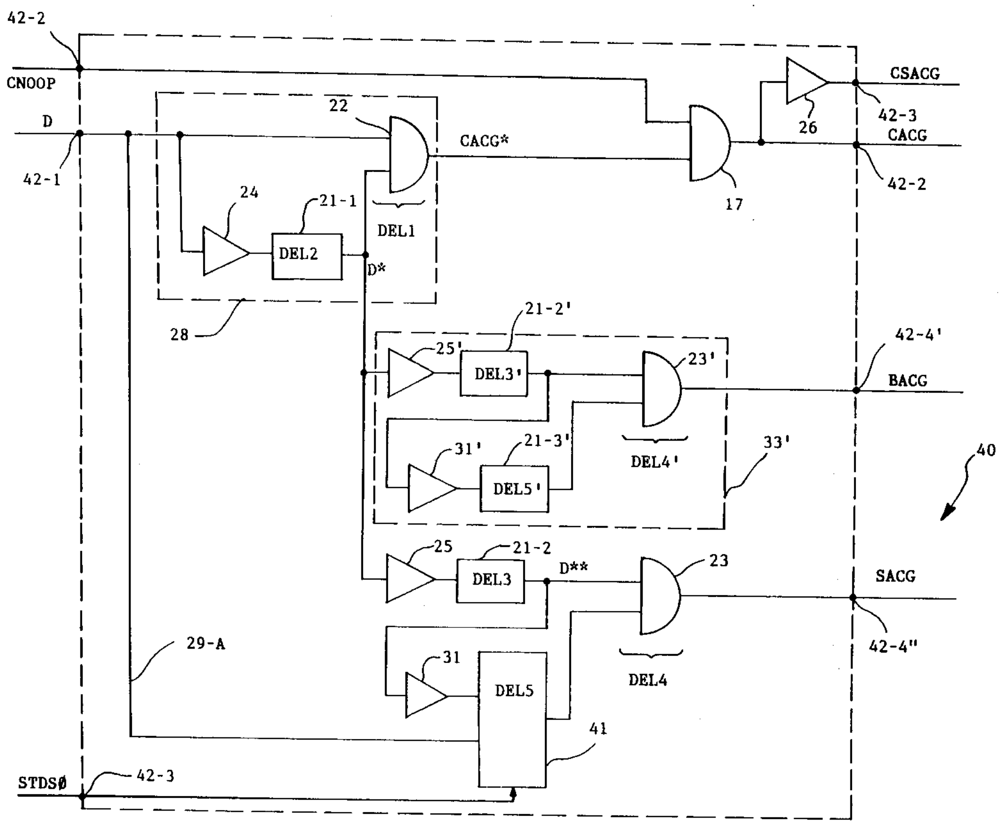

42-2
CNOOP
D
42-1
22
CACG*
DEL1
24
21-1
DEL2
D*
28
17
26
CSACG
42-3
CACG
42-2
21-2'
42-4'
25'
DEL3'
23'
BACG
31'
21-3'
DEL5'
DEL4'
33'
40
25
21-2
DEL3
D**
23
SACG
42-4"
29-A
31
DEL5
DEL4
41
STDSØ
42-3


FIG. 4

The present invention relates to integrated circuits of the memory type, such as stand-alone SRAMs or logic arrays with embedded SRAM macros provided with built-in self-test capabilities for logic and memory fault detection, fabricated in semiconductor chips. It more particularly relates to a novel high speed and programmable array clock generator circuit to be used therein. As memories get faster, more complex and denser, there is an increasing demand on ABIST (Array Bult-in Self-Test) structures offering high speed and high test coverage, while consuming minimal area on the semiconductor chip.

For sake of illustration, Fig. 1 shows the block diagram architecture of a state of the art SRAM macro 10 provided with an ABIST unit 11. A similar architecture is described in Ref. D1: US-A-5 173 906 assigned to the assignee of the present invention. The functional units shown in Fig. 1, either form a part of a stand-alone SRAM or the SRAM macro of a logic array of an integrated circuit chip. In the latter case, the chip may include a plurality of such macros, each being provided with its own dedicated ABIST unit. The said integrated circuit chip is part of a wafer fabricated in a very large scale integration (VLSI) semiconductor technology and is designed according to level-sensitive scan design (LSSD) rules.

As known for those ordinary skilled in the art, the SRAM macro 10 of Fig. 1 has three basic operating modes. The first one is the SYSTEM mode, according to which the SRAM macro 10 is in normal operation, i.e. where the memory unit 12 is either read or written, using the data-in signals DATAIN1 to DATAINM, the SRAM address signals ADDIN1 to ADDINP, and the read/write control signal R/WIN (wherein M and P are the respective bit widths of the data-in bus DATAIN and the SRAM address bus ADDIN). The second mode is required because of the LSSD construction: the SCAN mode which is used for initialising/analysing (SCAN-IN/SCAN-OUT) all the data of the latch pairs, which are used extensively in the SRAM macro architecture of Fig. 1, to form the LSSD chain. Finally, the third mode is the ABIST mode, in which the memory unit 12 functionality is tested. It is a self-test which is first performed in the manufacturing environment, before the chip is commercially released. A slightly different, more relaxed self-test is performed while the chip is incorporated in a system, for example at the customer location, and thus in the system environment. As a result, the ABIST mode is used in different environments referred to hereinbelow as the ABIST mfg sub-mode and the ABIST system sub-mode.

In the ABIST mode, according to the fundamentals of the self-test technique, the ABIST unit 11 generates a plurality of test pattern sequences. Each test pattern consists of a set of deterministic one's and zero's that are first written into the memory unit 12, then read out and compared with the expected pattern. Said test pattern sequences have thus the key role of exercising the memory unit 12 in order to verify, with a given precision, whether or not the memory unit 12 under test is properly functioning, i.e. to determine whether the READ and WRITE operations have been successful or not. To that end, the ABIST unit 11 generates self-test data signals STDATA, self-test address signals STADD, and the self-test read/write control signal STRW.

Three groups of multiplexers have the role of selecting the signals to be fed in the memory unit 12, i.e. either the external signals mentioned above coming from outside the SRAM macro 10, i.e. the DATAIN1 to DATAINM, ADDIN1 to ADDINP, and R/WIN signals, or the internal self-test signals generated by the ABIST unit 11 mentioned above i.e. the STDATA, STADD, and STRW signals. In Fig. 1, the multiplexers forming these three groups are respectively referenced 13-1 to 13-M, 13'-1 to 13'-P, and 13''. The selection is made under the control of the ABIST control signal. Usually, when the ABIST signal is held at the logic "0", the external signals are selected and when held at the logic "1", the signals that are internally generated by the ABIST unit 11 are selected. The ABIST signal thus allows the SRAM macro 10 to operate either in the SYSTEM mode or in the ABIST mode. The said three groups of multiplexers, i.e. 13-1 to 13-M, 13'-1 to 13'-P, and 13'' form multiplexer block 13. The outputs of the first and second groups are labelled DATA bus and ADD bus, with M and P respective bit widths. The output of multiplexer 13'' is a single wire which transports the R/W control signal which determines the READ/WRITE operating mode of memory unit 12.

The data-out signals that are output by the memory unit 12 are stored in a battery of data-out L1/L2 latch pairs referenced 14-1 to 14-M forming the data-out shift register unit 14. Generally, these data-out latch pairs are incorporated in the memory unit 12. The data-out signals that are output by the L1 and L2 latches are labelled DATAOUT1 to DATAOUTM (DATAOUT bus) and DOUT1 to DOUTM (DOUT bus) respectively. In the ABIST mode, after a READ operation has been performed, expected data signals labelled EXDATA are generated by the ABIST unit 11 on the EXDATA bus and compared in the data compression unit 15 with the data-out signals DOUT1 to DOUTM. Typically, only four test patterns are used on each word of the memory unit 12: alternate zero's and one's, i.e. 0101...01 and 1010...10), all zero's and all one's. In others words, there are only four self-test data signals, labelled STDATA0, STDATA1 and their respective complements. Because of the particular structure of these four test patterns, the data-out signals DOUT1 to DOUTM are divided into even and odd data-out signals. The even data-out signals that are output from the data-out shift register unit 14 are labelled DOUT2, DOUT4,..., DOUT2j, and similarly, the odd data-out signals are labelled DOUT1, DOUT3,..., DOUT(2j-1), where j is an integer equal to M/2, assuming M is an even number. Therefore, as all the even and odd numbered bits of the data-out signals are at the same '0' or '1' value at the same time, only two expected data signals, each one consisting of a single bit, labelled EXDATA0 and EXDATA1 are required. For instance, assuming the data-out signals to be read on the DOUT bus are: 010101...01, the expected data signal EXDATA0 (for the even numbered bits) will be "1" and the expected data signal EXDATA1 (for the odd numbered bits) will be "0". Said EXDATA0 and EXDATA1 signals are thus the expected results for the even and odd data-out signals respectively. Finally, data compression unit 15 generates a signal labelled RESULT which is held at a high logic level, i.e. the "1" logic state, if there is a mismatch during the comparison. By mismatch, it is meant that at least one data-out signal does not have the same logic value as its corresponding even or odd expected data generated by the ABIST structure 11. This mismatch is often caused by a defective word line in the memory unit 12 at a determined address. This mismatch is usually referred to as a "fail". On the contrary, if all data-out signals match with the corresponding even or odd expected data signals (which means no fail is detected), then the RESULT signal is held at the low logic level, i.e. the "0" logic state. The RESULT signal, which is often referred to in the literature as the FAIL FOUND LAST CYCLE signal, indicates after a READ operation, whether the memory unit 12 at the current address being tested, is defective or not. The RESULT signal is therefore indicative of the fail/no fail status of memory unit 12, on a cycle by cycle basis. Another key component of the state of the art SRAM macro 10 is the fail register unit 16. It is required because, in the ABIST mfg sub-mode, the addresses of the defective word dines have to be identified, then memorized for subsequent use in the SYSTEM mode. When the RESULT signal is raised to a logic "1", indicating thereby existence of a fail, the word portion of the current address generated by the ABIST unit 11 on the STADD bus, labelled STADD*, is stored in a bank of latch pairs of this fail address register unit 16. This stored word address thus corresponds to the address of a defective word line.

The ABIST unit 11 also generates a CNOOP (NOOP stands for NO OPERATION) signal to inhibit the ABIST self-test mode, when the totality of the test pattern sequences has been fully exercised on the memory unit 12. This signal is absolutely required when there is a plurality of SRAM macros embedded in a single semiconductor chip. Said macros may have different sizes thus requiring different durations for their respective test. The CNOOP signal generated by the ABIST unit of each SRAM macro allows the memory units of all macros to be simultaneously tested.

The general clocking of SRAM macro 10 is achieved as standard in accordance with LSSD rules. In the state of the art architecture of the SRAM macro 10 illustrated in Fig. 1, the clocking would be normally implemented by standard external LSSD clock signals labelled A, B, C, and S, and by the CS (CHIP SELECT for a stand-alone SRAM chip or ARRAY SELECT for a SRAM macro) signal. Note that the S clock signal, which is substantially the same as the B clock signal, is applied to the L2 latches of latch pairs 14-1 to 14-M of data-out shift register unit 14. In the ABIST mfg sub-mode, the clock and CS signals are derived from the tester. In the ABIST system sub-mode, these signals are derived from the system clock. The SCAN-IN (SI) signal is applied to the ABIST unit 11 according to the standard LSSD rules, as illustrated in Fig. 1. However, for sake of simplicity, the SCAN-OUT signal generated by the ABIST unit 11 in response to the SCAN-IN signal, to be applied as the SCAN-IN signal to the next latch pair, and so on, along the whole LSSD chain, has not been represented. In the following description, only latches will be mentioned while it is clear, that according to the LSSD concept, they are latch pairs in reality. All these signals are directly applied to the ABIST unit 11 and/or the memory unit 12, except the C clock and CS signals. The C clock signal is applied to one input of 2-way AND gate 17A. The CS signal is applied to one input of 2-way AND gate 17B. The CNOOP signal is applied to the other input of these AND gates 17A and 17B as a gating signal, in order to block, when needed, the transmission of the respective C clock and CS signal. This occurs when the self-test has been completed in the ABIST mode, and permanently in the SYSTEM mode. The A, B, and S clock signals are used during the SCAN mode, and the B, C, S and CS signals are used during the ABIST mode. The CS signal is used alone in the SYSTEM mode, and the LSSD clock signals are held in a non-active state. Numeral 18 schematically illustrates the clock distribution scheme in the SRAM macro 10 and also includes the internal chip clock distribution network servicing it. This terminates the description of a state of the art SRAM macro provided with an ABIST structure.

In the ABIST mode, it is essential to verify the memory unit 12 functions correctly with a very short system cycle time (tc). More particularly, in the ABIST mfg sub-mode, it is absolutely required to proceed to a very accurate measurement of the memory access time (ta). To date, there is a continous trend to decrease the system cycle times, as well as to design high speed SRAM macros with ever reduced memory access times. In that regards, it is really difficult, if not impossible, to test the memory unit 12 of the SRAM macro 10 of Fig. 1, at such short system cycle time and to make accurate memory access time measurements with the clock distribution scheme 18, because of the unacceptable imprecision due to uncontrollable clock signal skews.

This is particularly true in the ABIST mfg sub-mode, where this imprecision, inherent to this clock distribution scheme 18, comes from different factors such as: tester limitations, width variations of the clock signals generated by the tester, off-chip line delays caused by the lines between the tester and the chip, the chip internal clock distribution network, ... etc. In addition, with the state of the art SRAM macro 10 of Fig.1, calibration of the clock signals generated by the tester is required. This calibration is process dependent and thus has to be done for each product chip lot. The calibration is achieved by estimating the internal delays after accurate kerf measurements. As a result, it is very expensive and time consuming to perform an accurate memory access time measurement in the ABIST mfg sub-mode, because it requires high performance and expensive testers.

However, this skew concern also exists in the ABIST system sub-mode. It is still caused by the said chip internal clock distribution network and by mismatches in the internal chip path delay thereof. For each clock signal, the mismatch results from physical wiring layout imbalances and device differences between the driver circuits that buffer the clock signals, which in turn result in layout and process dependency.

In contrast with the approach illustrated in conjunction with Fig. 1, the present invention aims to overcome all these inconveniences, based on the fact that the development of high speed SRAM macros would advantageously necessitate the inclusion of a dedicated array clock generator (ACG) circuit within each macro, in place of the clock distribution scheme 18. This ACG circuit is driven by a single input D clock signal and generates all the clock signals that are required for a proper operation of the ABIST mode. Said input D clock signal is supplied externally to the SRAM macro either from the tester in the ABIST mfg sub-mode or from a signal directly derived from the system clock in the ABIST system sub-mode. In summary, the novel ACG circuit generates from a single input D clock signal, the LSSD B, C and S clock signals required by the ABIST structure and the CS signal required by the memory unit.

The ACG circuit of the present invention, first comprises a chopper circuit which generates an ungated clock signal (CACG*) at its output in response to said single input D clock signal. This ungated signal and a gating signal (CNOOP) supplied by the ABIST unit 11 are applied to a 2-way AND to generate the LSSD C clock signal (CACG), that is thus inhibited when the SRAM macro 10 is not in the ABIST mode. The ARRAY SELECT (CSACG) signal is derived therefrom via a second inverter. This chopper circuit essentially consists of a first 2-way AND gate (inherent delay DEL1), whose first input is driven by said D clock signal and second input is likewise driven by said D clock signal, but via a first inverter and a first delay line (delay DEL2) serially connected. The output of said first delay line is also connected to the first input of a second 2-way AND gate (inherent delay DEL4) via a third inverter and a second delay line (delay DEL3). A 2-way multiplexer (inherent delay DEL5), controlled by a control signal STDS0, applies either directly the said D clock signal or the signal which is output by said second delay line, to the second input of said second 2-way AND gate, via a fourth inverter. LSSD clock signals B (BACG) and S (SACG) are available at the output of the said second 2-way AND gate. The role of the control signal STDS0 is thus to select the appropriate configuration for an optimized operation of the ACG circuit in either of the two ABIST sub-modes.

From this construction, it results a better synchronization between the clock signals (e.g. BACG, CACG, ...), the signals generated by the ABIST unit 11 in the ABIST mode (e.g. STDATA, EXDATA, ... ), and the memory data-out signals (DOUT1 ,..., DOUTM), because a precise clocking and a minimal clock skew are obtained. The novel ACG circuit allows two circuit configurations, each being optimized for its respective ABIST sub-mode. As a result, the correct functioning of the memory unit can be performed in either of the two ABIST sub-modes, for memory units with short cycle times. Finally, the novel ACG circuit is fully compatible with the new low cost test strategy (expensive testers are no longer required) and results in significantly more accurate memory access time measurements.

Therefore it is a primary object of the present invention to provide a dedicated array clock generator circuit capable of servicing any high speed SRAM macro including an ABIST unit in systems with short cycle times.

It is another object of the present invention to provide an array clock generator circuit for high speed SRAM macros including an ABIST unit, to generate the clock signals that are required during the ABIST mode with minimal clock signal skews.

It is another object of the present invention to provide an array clock generator circuit for high speed SRAM macros including an ABIST unit, which does not require high performance and expensive testers for an accurate measurement of the memory access time during the ABIST manufacturing sub-mode.

It is still another object of the present invention to provide an array clock generator circuit for high speed SRAM macros including an ABIST unit that has two circuit configurations that can be selected, each adapted to perform optimally in its ABIST sub-mode.

These objects will be accomplished in particular by an integrated circuit, incorporating at least one SRAM macro including a memory unit and an ABIST unit, further including the dedicated array clock generator circuit according to claim 1.

The features believed to be characteristic of this invention are set forth in the claims. The invention itself, however, as well as other objects and advantages thereof, may be best understood by reference to the following detailed description of an illustrated preferred embodiment to be read in conjunction with the accompanying drawings.

Fig. 1 shows the partial schematic view of the block diagram architecture of a state of the art SRAM macro including an ABIST unit.

Fig. 2A shows the schematic block diagram of a preferred embodiment of the array clock generator circuit of the present invention in the ABIST manufacturing sub-mode.

Fig. 2B shows waveforms of the clocking signals generated by the array clock generator circuit of Fig. 2A.

Fig. 3A shows the schematic block diagram of the preferred embodiment of the array clock generator circuit of the present invention in the ABIST system sub-mode.

Fig. 3B shows waveforms of the clocking signals generated by the array clock generator unit of Fig. 3A.

Fig. 4 shows the novel array clock generator circuit of the present invention which incorporates the two preferred embodiments of Figs. 2A and 3A.

Fig. 2A shows the detailed circuit construction of a preferred embodiment of the ACG circuit of the present invention optimized for the ABIST manufacturing sub-mode. According to this first configuration, the illustrated circuit referenced 20 in Fig. 2A, uses the two edges of an input clock signal labelled D which is generated by the tester in this sub-mode. Circuit 20 essentially comprises two delay lines 21-1 and 21-2 whose respective delays are labelled DEL2 and DEL3, two 2-way AND gates 22 and 23, and three inverters 24 to 26. It further includes an 2-way AND gate 16 whose role will be explained in due course. Input and output terminals are generically referenced 27. The D clock signal is applied to input terminal 27-1 which is connected to one input of AND gate 22 and to the input of inverter 24. The output of inverter 24 is connected to the input of delay line 21-1, whose output is connected to the second input of AND gate 22 and to the first input of AND gate 23 via inverter 25 and delay line 21-2. The signals at the output of delay lines 21-1 and 21-2 are respectively labelled D* and D**. The construction of AND gate 22, inverter 24 and delay line 21-1 results in a conventional signal chopper circuit referenced 28 in Fig. 2A. The delays inherent to AND gates 22 and 23 are respectively referred to as DEL1 and DEL4. The D clock signal is applied to the second input of AND gate 23 by connection 29 or optionally via a delay line 21-3 that introduces a delay DEL5. To facilitate the memory access time measurement, it is recommended to have DEL1 = DEL4 (or DEL1 = DEL4 + DEL5 if the option mentioned above is implemented). The ungated clock signal CACG* available at the output of AND gate 22 is gated in 2-way AND gate 16 by gating signal CNOOP generated by the ABIST unit 11 when inhibition of clock signal CACG at output terminal 27-2 is required. 2-way AND gate 17 plays thus the role of AND gates 17-A and 17-B of Fig. 1. The CSACG signal is available through inverter 26 at terminal 27-3. The BACG and the SACG signals are generated by AND gate 23 and are available at the same common output terminal 27-4.

Operation of circuit 20 will be better understood by reference to Fig. 2B. As apparent from Fig. 2B, which illustrates the timing diagrams of the signals generated by the ACG circuit 20 of Fig. 2A in the ABIST mfg sub-mode. The rising edge of the D Clock signal pulse initiates generation of the complete positive CACG clock signal, the complete negative CSACG signal, and the rising edges of both the BACG and SACG clock signals. The falling edge of the D clock signal initiates generation of the falling edges of the BACG and SACG (BACG/SACG) clock signals, after a delay equal to DEL4 (or DEL4 + DEL5). The width or duration W of the D clock signal determines when the SACG clock signal falls, which in turn, causes the data-out signals coming from the memory unit 12 to be captured in the data-out shift register unit 14 (Fig. 1). The BACG and SACG clock signals are thus primarily controlled by varying the pulse width W of the incoming D clock signal, so that the memory access time measurement, illustrated by delay ta in Fig. 2B, is performed by the ABIST unit 11. Note that, if delay DEL1 of AND gate 22 is preferably equal to delay DEL4 (or DEL4 + DEL5), then ta =

W as apparent from Fig. 2B. Moreover, these delays are preferably designed to track very closely with each other in terms of process variations. This means that any process variations in ACG circuit 20 will be subtracted out of the memory access time measurements. The tracking of these delays DEL1 and DEL4 (and possibly DEL5) ensures a more accurate access time measurement, because ACG circuit 20 is more process and layout independent. This first configuration is optimized for the ABIST mfg sub-mode, when the macros are individually tested on a serial basis by the external tester which can precisely control said width W of the D clock signal, that will be the same for all the macros of the chip. Circuit 20 thus allows an accurate memory access time measurement simply by varying the D clock signal pulse width when the chip is tested during the ABIST mfg sub-mode, and it is thus very easy to determine its operating limits. But, if a precise control of that pulse width is relatively simple in the manufacturing environment thanks to the tester, it is quite impossible in the system environment. The memory access time measurement is not performed in the ABIST system sub-mode, as it will be now explained.

The preferred embodiment of the ACG circuit of the present invention for the ABIST system sub-mode is shown in Fig. 3A, where it bears numeral 30. According to this second configuration, circuit 30 only uses the rising edge of the D clock signal as it will be explained later on. Fig. 3A circuit has a lot of common circuitry with the Fig.2A circuit as apparent from these drawings (where the common part has been emphasized by thick lines), according to a significant feature of the present invention. The identical hardware comprises the two delay lines 21-1 and 21-2, whose delays are still referenced DEL2 and DEL3, the two 2-way AND gates 22 and 23, and finally the three inverters 24 to 26 that are interconnected in the same way. Likewise, it still comprises AND gate 17 to gate the CACG* clock signal with the CNOOP signal. But now, the output of delay line 21-2 is not only connected to the first input of AND gate 23, but also, via inverter 31 and delay line 21-4 (delay DEL5), to the second input of said AND gate 23. AND gate 23, inverters 25 and 31, delay lines 21-2 and 21-4 form block 33. Input and output terminals are generically referenced 34. The D clock signal is applied to input terminal 34-1, and the clock signals CACG, CSACG, BACG/SACG generated by ACG circuit 30, are respectively available at output terminals 34-2 to 34-4.

Operation of circuit 30 will be better understood by reference to Fig. 3B. As apparent from Fig. 3B, which illustrates the timing diagrams of the signals generated by the ACG circuit 30 of Fig. 3A in the ABIST system sub-mode, the rising edge of the D clock signal pulse initiates generation of the complete positive CACG clock signal, the complete negative CSACG signal, and the complete BACG and SACG clock signals. The pulse widths of the LSSD BACG and SACG clock signals are thus independent of the D clock signal pulse width.

The configuration of circuit 30 is adequate for an optimal operation in the ABIST system sub-mode, where it is not possible to use the falling edge of the D clock signal to control the falling edge of the LSSD SACG and BACG clock signals. In this sub-mode, it is not possible to use the falling edge of the D clock signal for two reasons: firstly the D clock signal pulse width W is not easily controllable and secondly, because the memory units are tested in parallel, it cannot be asserted that the D clock signal pulse width will be adequate for all the said macros. A further advantage of the circuit 30 configuration is that the memory units of all the SRAM macros incorporated in a single chip, can be tested in parallel. This second configuration, in contrast to the first one, does not allow the accurate access time measurement of the memory unit, and thus, this measurement is not performed in the ABIST system sub-mode. Only, the self-test of the memory unit 12 is conducted by the ABIST unit 11.

Now turning to Fig. 4, there is described a preferred embodiment of the array clock generator (ACG) circuit referenced 40 of the present invention incorporating the two circuit configurations of Figs. 2A and 3A. To that end, the array clock generator circuit 40 is provided with a 2-way multiplexer 41, which allows the ACG circuit to operate in either of the two ABIST sub-modes. This multiplexer is controlled by a control signal labelled STDS0, which comes from the ABIST unit 11, allowing thereby a digital programmation of the appropriate configuration of circuit 40 depending on the selected ABIST sub-mode. This concept of programmation could be extended by using a 2**N-way multiplexer controlled by a plurality N of control signals STDS0, ... to further subdivide said two ABIST sub-modes, should other features (ex: sort, relaxed timing measurements and test convenience) be required. Input and output terminals are generically referenced 42. The D input clock signal is applied to input terminal 42-1, then directly fed to the first input of the two-way AND gate 22 and, via inverter 24 and delay line 21-1, on the second input of AND gate 22. This construction forms chopper circuit 28 as explained above. The latter generates the CACG* signal which is gated by the CNOOP signal in AND gate 17. The CSACG signal is derived therefrom via inverter 26 and is available at terminal 42-3. When CNOOP is low the CACG and CSACG clock signals must be gated off. When CNOOP is high, the CACG and CSACG clock signals are generated from the ACG circuit 40. The signal D* which is output by delay line 21-1, is also applied via inverter 25 and delay line 21-2 to the first input of 2-way AND gate 23, where it is labelled D**. Multiplexer 41, normally introduces an inherent delay DEL5 which corresponds to the delay produced either by optional delay line 21-3 in Fig. 2A or delay line 21-4 in Fig. 3A. Multiplexer 41 allows either the D clock signal, via shorted connecting wire 29A, or the signal D** which is output by delay line 21-2, via inverter 31, to be applied to the second input of AND gate 23. This selection is performed by STDS0 control signal which is applied to input terminal 42-2, depending on the selected ABIST sub-mode.

Clock signals CACG and SACG may be available at a single common output terminal (e.g. 42-4, not illustrated) but preferably, at separate terminals as shown in Fig. 4, where they are referenced 42-4' and 42-4''. In the latter case, clock signal SACG remains generated by AND gate 23 from signal D**, while clock signal BACG is generated by circuit 33', structurally identical to circuit 33 of Fig. 3A, but with different delays, for further optimization. This feature presents some interest in case the logic designer needs more freedom. ACG circuit 40 has two inputs one for the D Clock signal and the other for the STDS0 control signal. In turn, in the ABIST mode, the ACG circuit 40 generates the LSSD BACG and CACG clock signals for the ABIST unit 11 of Fig. 1, the CSACG signal and the SACG clock signal for the memory unit 12 and data-out shift register unit 14 respectively.

When STDS0 = 1, ACG circuit 40 operates according to the first configuration (circuit 20). The falling edge of the LSSD SACG and BACG clock signals are dependent on the falling edge of the D clock signal, as illustrated in Fig. 2B. When STDS0 = 0, ACG circuit 40 operates according to the second configuration (circuit 30). The falling edge of the LSSD BACG and SACG clock signals occur after the rising edge of the D clock signal i.e. after a fixed delay equal to the sum of internal delays as apparent from Fig. 3B.

As a result, multiplexer 41 gives a level of programmability to the ACG circuit 40 to optimally fulfill the needs of both ABIST sub-modes. In the ABIST mfg sub-mode (Fig. 2B), the SACG clock signal falling edge is given by the D clock falling edge thus allowing the precise measure of the memory access time. In addition, as each SRAM macro contains its own ACG circuit, it is very easy to adjust the D clock signal falling edge to measure the memory access time of each memory unit using its own dedicated ABIST unit 11. Moreover, it is relatively process independent. In the ABIST system sub-mode, the SACG clock signal pulse width is only fixed by the sum of internal delays of the ACG circuit 40 (which are so designed to insure that the data-out signals coming from the memory unit 12 are captured in latches 14-1 to 14-M of unit 14. In this submode, the clock signal generation is independent of the D clock signal pulse width and there is no measurement of the memory access time.

It should be noticed that the state of the art SRAM macro architecture of Fig. 1 could operate (not illustrated in Fig. 4) either with the internally generated clock signals from the ACG circuit 40 in accordance with the present invention, or with the standard separate external LSSD clock signals. It suffices to introduce appropriate OR gates in the signal paths as admittedly within the scope of those skilled in the art. However, when using the ACG circuit 40 of the present invention, it is possible to run the ABIST unit 11 with a single clock which in turn, generates the ARRAY SELECT (CSACG) signal, the LSSD B (BACG), C (CACG) and the S (SACG) clock signals. On the contrary, when running the ABIST unit 11 with separate LSSD clock signals according to the clock distribution scheme 18, it is necessary to control the CS, B, C and the S signals externally to the SRAM macro 10. The SCAN-IN mode which is composed of alternating A and B clock signals, can be controlled only by the separate external LSSD clock signals and cannot be controlled by the ACG circuit 40.

The ACG circuit 40 described above has been implemented in a silicon chip using a BiCMOS 0.8um technology. It has demonstrated to be operative with a D clock signal running at 200 MHz (i.e. a 5ns system cycle time). Moreover, the ACG circuit 40 is a high performance circuit, since it runs faster than this system cycle time. Circuit 40 can be implemented in any bipolar BiCMOS and CMOS technology. The ACG circuit 40 reduces the skew between clock signals due to the tester imprecision, to a minimum i.e. the skew due to device mismatching, typically from 300ps to about 50ps.

As a matter of fact, this latter skew is inherent to any clock distribution scheme that is internally buffered. The novel ACG circuit fully satisfies the new low cost test strategy and performs the highly precise measurements that are required to date.

Although the present invention has been described for an SRAM macro, the ACG circuit 40 may find large applications in DRAMs, flash memories ...etc.

## Claims

1. An integrated circuit incorporating at least one SRAM macro (10) of the type including a memory unit (12), a data-out shift register unit (14), a dedicated ABIST unit (11), a data compression circuit (15), a fail address register unit (16) and a dedicated array clock generator (ACG) circuit (40) characterized in that said ACG circuit includes:

a first input terminal (42-1) adapted to receive a single input clock signal (D);

a second input terminal (42-2) adapted to receive a gating signal (CNOOP) from the ABIST unit;

a third input terminal (42-3) adapted to receive a control signal (STDS0) from the ABIST unit;

a signal chopper (28) comprised of a first AND gate (22) having an inherent delay DEL1 whose first input is connected to said first input terminal and whose second input is connected to said first input terminal via a first inverter (24) and a first delay line (21-1) having a determined delay DEL2 to generate an ungated LSSD C clock signal (CACG*); and,

a second AND gate (23) having an inherent delay DEL4 whose first input is connected to the output of said first delay line via a second inverter (25) and a second delay line (21-2) having a determined delay DEL3 and whose second input is either directly connected (29) to said input clock signal or to the output of said second inverter via a third inverter (31) and a third delay line (21-4) having a determined delay DEL5 to generate the LSSD B (BACG) and S (SACG) clock signals.

2. The ACG circuit of claim 1 wherein said LSSD C ungated clock signal is gated in an AND gate (17) by said gating signal (CNOOP) supplied by the ABIST unit to generate the LSSD C clock signal (CACG).

3. The ACG circuit of claim 2 wherein the ARRAY SELECT clock signal (CSACG) is derived from the LSSD C clock signal (CACG) by a fourth inverter (26).

4. The ACG circuit of any above claim wherein said direct connection includes a fourth delay line (21-3) having a determined delay (DEL5);

5. The ACG circuit of any above claim wherein said delay lines (21-3 or 21-4) having a determined delay DEL5 are replaced by a multiplexor (41) having an inherent delay (DEL5) and controlled by said control signal (STDS0).

6. The ACG circuit of any above claim wherein delay DEL1 is approximately equals to DEL4 or to the sum of delays DEL4 + DEL5.

7. The ACG circuit of any above claim further comprising a specific circuit (33') to deliver a LSSD B clock signal different from the LSSD S clock signal.

8. The ACG circuit of claim 7 wherein said specific circuit is driven by the signal (D*) which is output by said first delay line and consists of an AND gate (23') having an internal delay (DEL4') whose first input is connected to said signal (D*) via an inverter (25') and a fifth delay line (21-2') having an internal delay (DEL3') and its second input is connected to the output of said fifth delay line via an inverter (31') and a delay line (21-3') having a predetermined delay (DEL5').

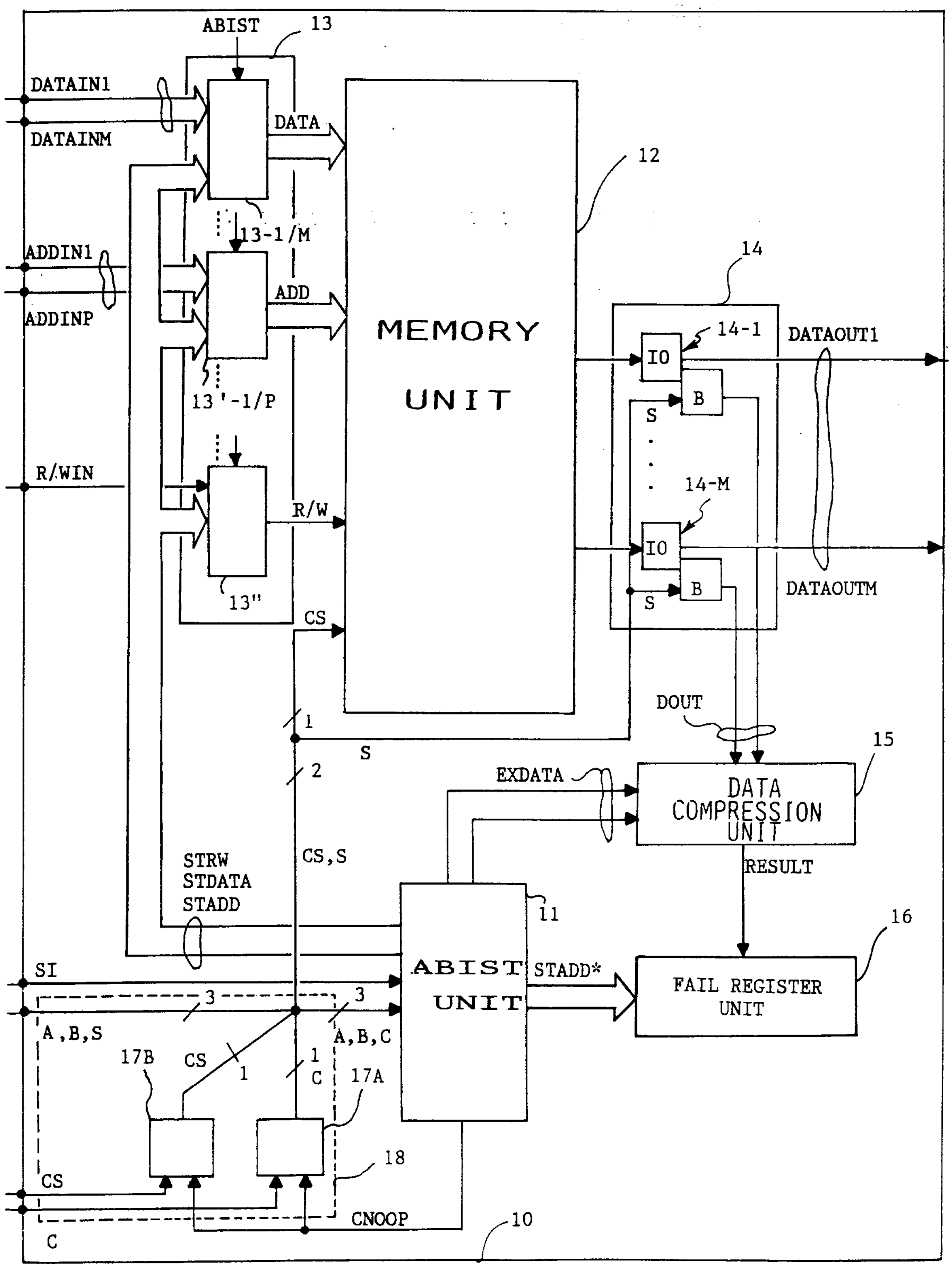


FIG.1 Prior Art

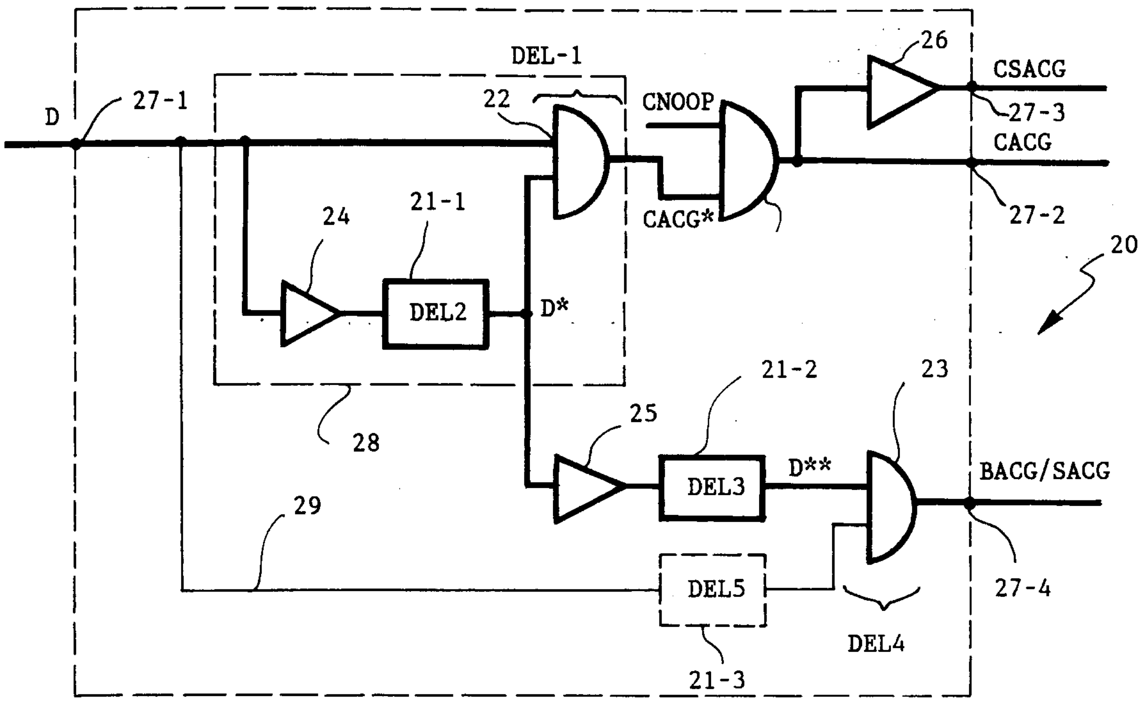
D
27-1
DEL-1
22
CNOOP
26
CSACG
27-3
CACG
27-2
20
24
21-1
DEL2
D*
CACG*
28
21-2
23
25
DEL3
D**
BACG/SACG
29
DEL5
27-4
DEL4
21-3

FIG. 2A

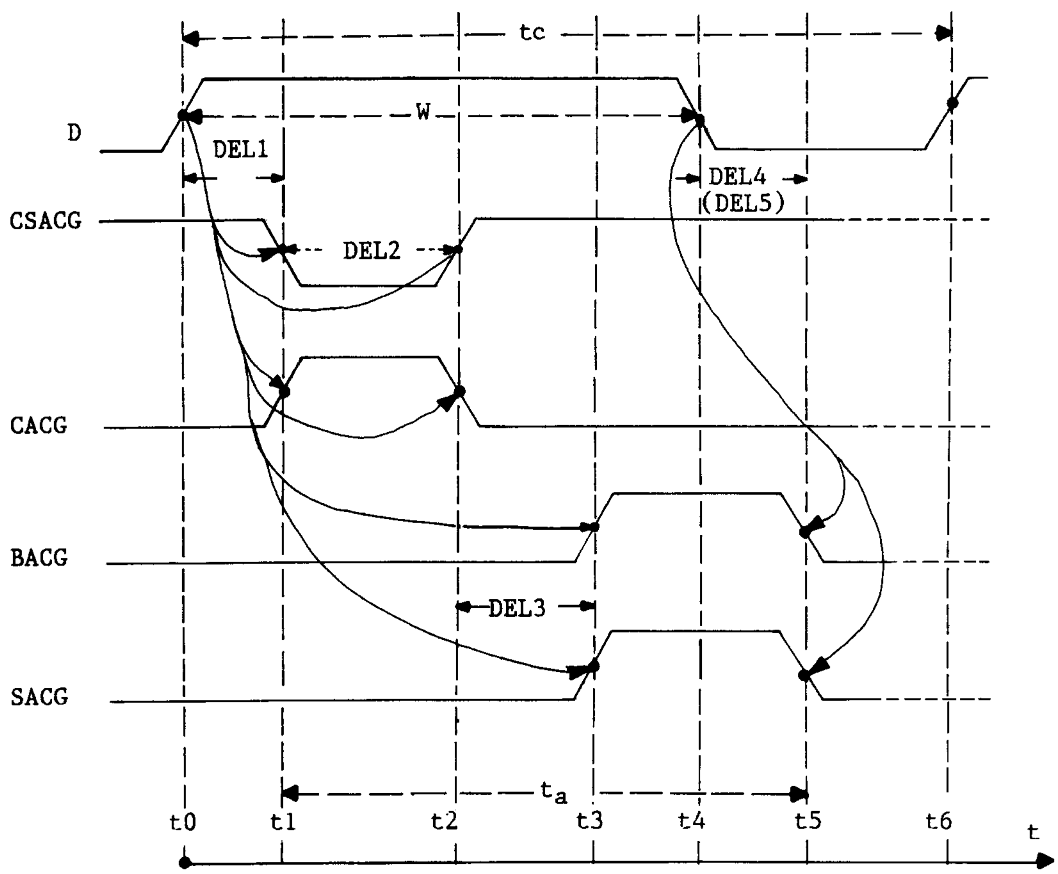
tc
W
D
DEL1
DEL4
(DEL5)
CSACG
DEL2
CACG
BACG
DEL3
SACG
$t_a$
t0
t1
t2
t3
t4
t5
t6
t

FIG. 2B

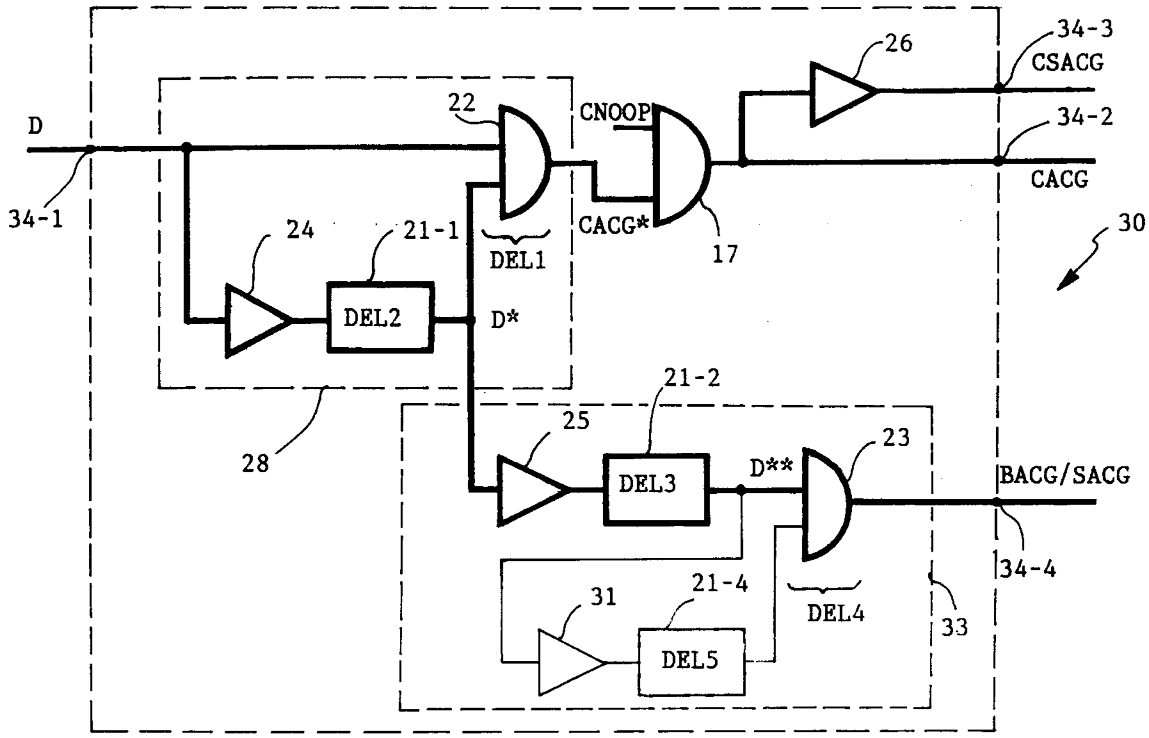
D
34-1
22
CNOOP
34-3
CSACG
26
34-2
CACG
CACG*
DEL1
17
30
24
21-1
DEL2
D*
28
21-2
25
DEL3
D**
23
BACG/SACG
34-4
31
21-4
DEL5
DEL4
33

FIG. 3A

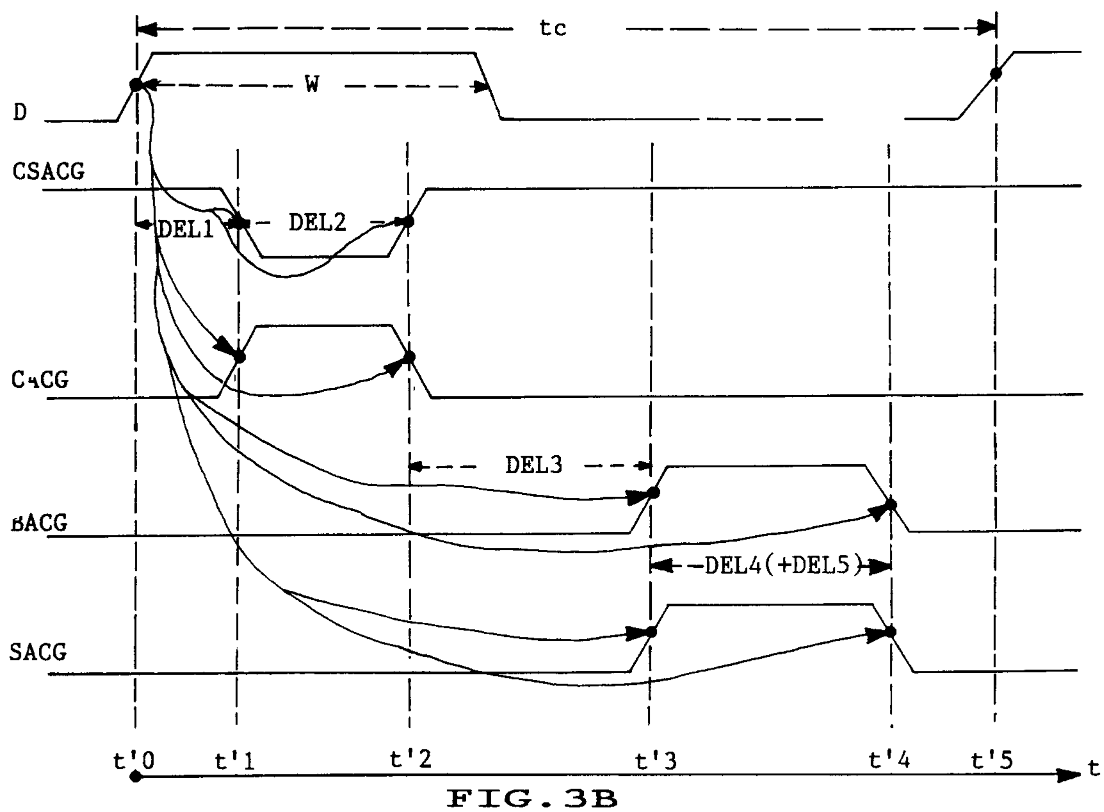
tc
W
D
CSACG
DEL1
DEL2
CACG
DEL3
BACG
DEL4(+DEL5)
SACG
t'0
t'1
t'2
t'3
t'4
t'5
t

FIG. 3B

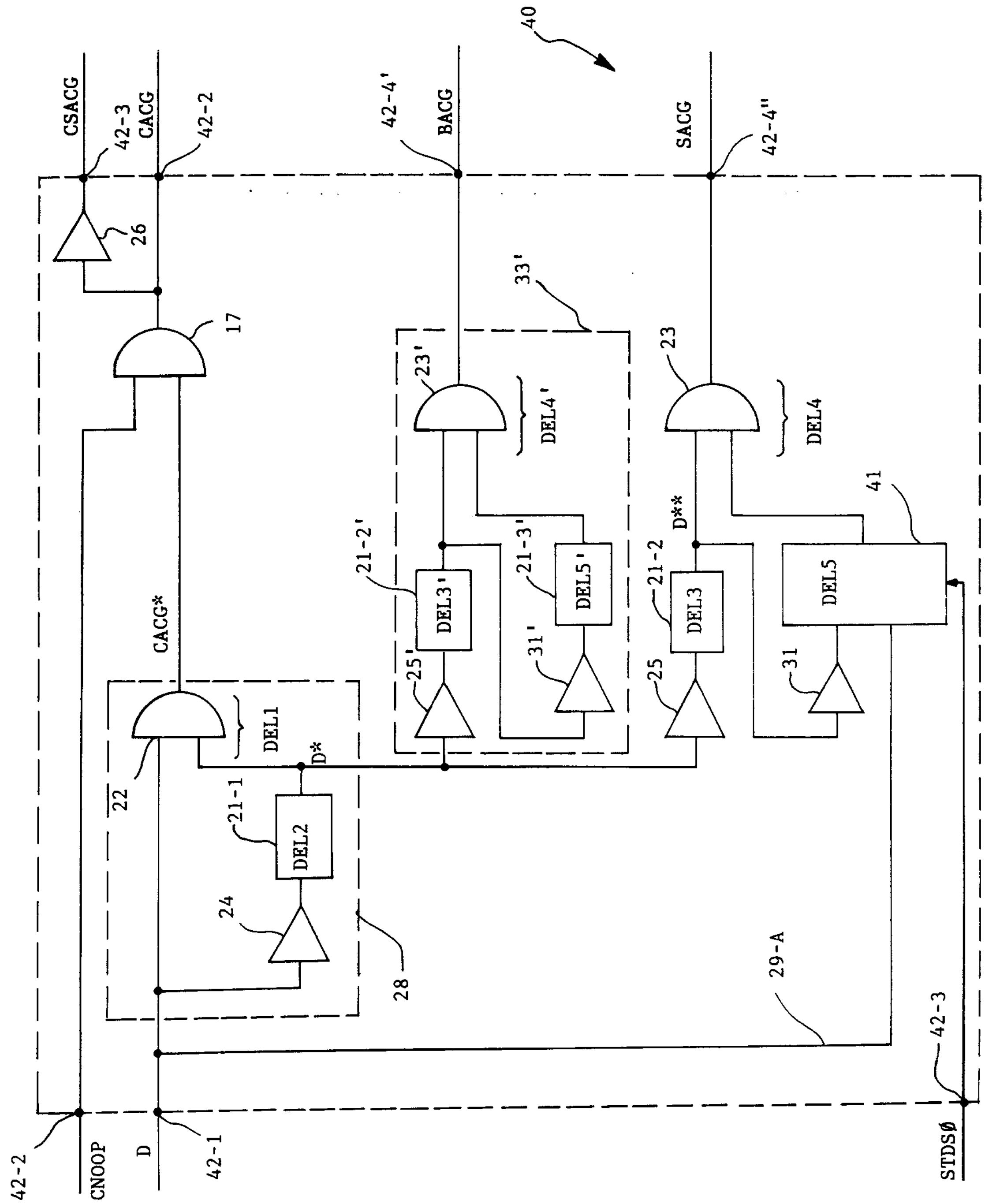
40
CSACG
42-3
CACG
42-2
42-4'
BACG
SACG
42-4"
26
17
33'
23'
DEL4'
23
DEL4
21-2'
21-3'
DEL3'
DEL5'
21-2
D**
DEL3
41
DEL5
CACG*
25'
31'
25
31
DEL1
22
D*
21-1
DEL2
24
28
29-A
42-3
42-2
CNOOP
D
42-1
STDSØ

FIG. 4

European Patent Office

# EUROPEAN SEARCH REPORT

Application Number
EP 93 48 0085

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-4 692 633 (NGAI ET AL.)<br>* abstract; claim 1; figure 5 *<br>--- | 1 | G06F11/26<br>H03K5/15 |
| A | US-A-5 172 010 (MONTEGARI)<br>* abstract; claim 1 *<br>----- | 1 | |
| | | | TECHNICAL FIELDS SEARCHED (Int.Cl.6) |
| | | | G06F<br>H03K |

The present search report has been drawn up for all claims

| Place of search | Date of completion of the search | Examiner |
|---|---|---|
| THE HAGUE | 30 November 1993 | Sarasua Garcia, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document